# EUROPEAN PATENT SPECIFICATION

(11) **EP 3 968 083 B1**
(45) Date of publication and mention of the grant of the patent: **07.08.2024**
(21) Application number: 20822280.2
(22) Date of filing: 05.06.2020
(51) Int. Cl.: G02C 7/10, G02B 1/115, G02B 5/00, C23C 14/08, C23C 14/20, G02B 5/20, G02B 5/22

(54) **PLASTIC SUBSTRATE ND FILTER AND PLASTIC SUBSTRATE ND FILTER FOR USE IN EYEGLASSES**
KUNSTSTOFFSUBSTRAT-ND-FILTER UND KUNSTSTOFFSUBSTRAT-ND-FILTER ZUR VERWENDUNG BEI BRILLEN
FILTRE ND À SUBSTRAT EN PLASTIQUE ET FILTRE ND À SUBSTRAT EN PLASTIQUE DESTINÉ À ÊTRE UTILISÉ DANS DES LUNETTES

(30) Priority: 11.06.2019 JP 2019108919
(43) Date of publication of application: 16.03.2022
(73) Proprietor: Tokai Optical Co., Ltd., Okazaki-shi, Aichi 444-2192 (JP)
(72) Inventor: SUZUKI, Ryosuke, Okazaki-shi, Aichi 444-2192 (JP)
(74) Representative: Prüfer & Partner mbB Patentanwälte · Rechtsanwälte
(86) International application number: PCT/JP2020/022402
(87) International publication number: WO 2020/250837

(56) References cited:
- EP-A1- 3 407 100
- WO-A1-2017/145910
- JP-A- 2001 074 911
- JP-A- 2001 074 911
- JP-A- 2002 341 107
- JP-A- 2018 036 325

## Description

### TECHNICAL FIELD

The present invention relates to a neutral density (ND) filter having a plastic substrate (base), and an eyeglass (spectacle) ND filter using the ND filter.

### BACKGROUND ART

JP 2001 074911 A discloses a conductive antireflection film on a glass panel consisting of, from the base body side, a first layer of a color conductive layer essentially comprising TiN having 1.1 to 2.3 refractive index and 0.5 to 30 mm film thickness, second layer of transparent layer having 1.5 to 2.3 refractive index and 10 to 80 nm film thickness, third layer of color layer essentially comprising Ni oxide and having 0.5 to 40 nm film thickness, fourth layer of a transparent layer having a smaller refractive index than that of the second layer and having 3 to 40 nm film thickness, fifth layer of transparent layer having 1.5 to 3.0 refractive index and 0.5 to 40 nm film thickness, sixth layer of transparent layer having 1.4 to 1.6 refractive index and 50 to 140 nm film thickness. The panel is obtained by forming the film on the face part.

An example of ND filters for spectacles is described in Japanese Laid-Open Patent Publication No. 2017-151430.

A light absorbing film of this ND filter has a plurality of layers in which a first layer (initial layer) from a base made of resin such as episulfide (refractive index is approximately 1.76) is a SiO₂ layer or an Al₂O₃ layer, and one or more NiOₓ layers (x is not less than 0 and not greater than 1) are included.

### SUMMARY OF THE INVENTION

### PROBLEMS TO BE SOLVED BY THE INVENTION

In a case where the above ND filter is formed such that a light absorbing film including an Al₂O₃ layer is formed on a substrate made of thiourethane (refractive index is approximately 1.60), there is a possibility that at least one of processing crack and transmittance abnormality occurs in a constant temperature and humidity test (accelerating test) after lens shape processing.

Specifically, episulfide hardly absorbs moisture, and when subjected to an external force, hardly extends and thus is broken, whereas thiourethane readily absorbs moisture, and is deformable to a certain extent so as to follow an external force. In addition, as compared to SiO₂ and ZrO₂, Al₂O₃ is less extendable by an external force. Then, in lens shape processing, the thiourethane base is slightly deformed, and at this time, there is a possibility that invisible minute crack occurs in the Al₂O₃ layer which is less extendable. In the constant temperature and humidity test, moisture concentrates on the minute crack, so that there is a possibility that visible crack occurs in the light absorbing film or moisture acts on the NiOₓ layer to cause transmittance abnormality.

In addition, in the case where the above ND filter is formed such that the light absorbing film including the Al₂O₃ layer is formed on the substrate made of thiourethane, there is a possibility that, in the constant temperature and humidity test, strain occurs in the film formed surface to cause outer appearance abnormality.

Specifically, in the constant temperature and humidity test, the thiourethane base swells through moisture absorption while the Al₂O₃ layer cannot follow the base, so that outer appearance abnormality might occur.

Accordingly, a main object of the present invention is to provide a ND filter and a spectacle ND filter that have a plastic base made of thiourethane or the like and that have excellent durability.

### SOLUTION TO THE PROBLEMS

The above object is achieved by the plastic base ND filter according to claim 1 and the spectacle plastic base ND filter according to claim 10.

### ADVANTAGEOUS EFFECTS OF THE INVENTION

A main effect of the present invention is that it becomes possible to provide a ND filter and a spectacle ND filter that have a plastic base made of thiourethane or the like and that have excellent durability.

### BRIEF DESCRIPTION OF THE DRAWINGS

FIG. 1 is a graph showing spectral transmittance distributions in a visible region and a neighboring region, in Examples 1 to 5 according to the present invention and Comparative examples 1 and 2 not belonging to the present invention.
FIG. 2 is a graph showing spectral transmittance distributions in the visible region, in Examples 5 to 7 according to the present invention.
FIG. 3 shows spectral reflectance distributions (one surface) in the visible region and the neighboring region, on a concave surface (ND film formed surface) side in Examples 1 to 5 and Comparative examples 1 and 2.
FIG. 4 is a graph showing spectral reflectance distributions (one surface) in the visible region and the neighboring region on a concave surface (ND film formed surface) side in Examples 5 to 7.
FIG. 5 is a graph showing a spectral reflectance distribution (one surface, common) in the visible region, on a convex surface side in Examples 1 to 7.
FIG. 6 is a graph showing spectral reflectance distributions (one surface) in the visible region and the neighboring region, for a part where peeling occurred (peeled part) after a weather-resistance and adhesion test in Comparative example 2, and simulation in a case where layers up to the third layer from the base side remained in a light absorbing film while the fourth and subsequent layers were lost.

### DESCRIPTION OF EMBODIMENTS

Hereinafter, exemplary embodiments according to the present invention will be described with reference to the drawings as necessary.

A ND filter according to the present invention is a filter that uniformly absorbs at least light (visible light) whose wavelength is in a visible region (e.g., not less than 400 nanometers (nm) and not greater than 800 nm, not less than 400 nm and not greater than 760 nm, not less than 400 nm and not greater than 700 nm, not less than 410 nm and not greater than 760 nm, or not less than 420 nm and not greater than 760 nm).

A base of the ND filter is made of a transparent (including translucent as appropriate) plastic. Examples of a material of the base include polyurethane resin, thiourethane resin, episulfide resin, polycarbonate resin, acrylic resin, polyether sulfone resin, poly(4-methylpentene-1) resin, and diethylene glycol bis(allyl carbonate) resin.

The base may be a convex lens, a concave lens, or a flat lens, and the power and the progressive power of the base may be set freely.

The ND filter of the present invention may be used for any application as long as the base is made of plastic. The ND filter of the present invention is preferably used for a camera so as to be included in a part of a camera lens system (e.g., used for protecting another lens or incorporated in a camera body) or similarly used for a projector, binoculars, or a telescope, and more preferably used for spectacles (used as a spectacle lens itself or used as an over-spectacle lens for covering a spectacle lens).

An optical multilayer film is formed on one surface or both surfaces of the base.

The optical multilayer film mainly has a function of uniformly absorbing visible light, and further has a function of preventing reflection of the visible light as appropriate. The optical multilayer film or a part thereof for absorbing visible light is a light absorbing film. When the light absorbing film is formed from one layer, the light absorbing film may be a light absorbing layer. Meanwhile, the optical multilayer film or a part thereof for preventing reflection of visible light is an antireflection film. The antireflection film may include a light absorbing film. In a case where the optical multilayer films are provided on both surfaces of the base, both optical multilayer films may have the same structure, or may have different structures.

The optical multilayer film may be formed from a light absorbing film only. The optical multilayer film may have an antifouling film or a protective film added on the front surface side (air side) of the light absorbing film. The optical multilayer film may have a single or a plurality of intermediate layers, such as a hard coating film, added on the base side of the light absorbing film. The optical multilayer film may have a single or a plurality of layers or films added inside or outside the light absorbing film, for another purpose such as improvement of conductivity. The optical multilayer film may be obtained by combination of the above layers and/or films. A hard coating film, a conductive layer, an antireflection film, or the like may not be included in the optical multilayer film. Each of them or a combination thereof may be formed as a separate optical multilayer film.

The hard coating film is formed from, for example, an organosiloxane compound, or is formed from an organosilicon compound or an acrylic compound.

As an underlayer (layer on the base side) of the hard coating film, a primer layer may be provided. The primer layer is formed from, for example, at least one of polyurethane-based resin, acrylic resin, methacrylic resin, and organosilicon resin.

The antireflection film is formed from, for example, a plurality of kinds of dielectric materials including a low refractive index material and a high refractive index material. As the low refractive index material, for example, at least one of silicon oxide (in particular, SiOz) and magnesium fluoride (in particular, MgF₂) is used. As the high refractive index material, for example, at least one of zirconium oxide (in particular, ZrOz), titanium oxide (in particular, TiOz), tantalum oxide (in particular, Ta₂O₅), and niobium oxide (in particular, Nb₂O₅) is used. The antireflection film is preferably formed such that the low refractive index materials and the high refractive index materials are alternately layered with either of the low and high refractive index materials positioned on the base side.

The light absorbing film is formed so as to have one or more light absorbing layers containing nickel (Ni).

As Ni, the simple substance may be used, but an unsaturated metal oxide film is preferably used. The unsaturated metal oxide film of Ni, hereinafter refer to as NiOₓ (x is greater than 0 and not greater than 1). For example, in a case where Ni is a deposition material, the value of x can be adjusted through deposition in a state in which oxygen gas is supplied into a deposition vacuum device at a predetermined flow rate, and if no oxygen gas is supplied, x is 0 (simple substance).

The light absorbing film may be formed as a multilayer film having another layer. In this case, examples of the other layer include a ZrOz layer, an Al₂O₃ layer, a silica compound layer such as a SiOz layer, and a combination thereof. The silica compound is a silicon compound or a mixture of a silicon compound and another compound. The silica compound is preferably a mixture of silicon oxide and aluminum oxide, and is more preferably a mixture of SiOz and Al₂O₃.

If the light absorbing film has a silica compound layer or the like covering the light absorbing layer, i.e., the NiOₓ layer (x is not less than 0 and not greater than 1), the light absorbing layer is protected from formation of flaw and alteration due to moisture.

On the opposite side (air side) of at least one light absorbing layer from the base, a sandwich structure portion in which a reverse stress layer is sandwiched between silica compound layers, is provided. Specifically, the sandwich structure portion is a portion in which the silica compound layer, the reverse stress layer, and the silica compound layer are arranged in this order from the base side, and is provided on the air side of any of the light absorbing layers.

The sandwich structure portion can be considered to be a portion in which the reverse stress layer is inserted at the center of one silica compound layer so that the silica compound layer is divided into two layers. Owing to the film strength of the silica compound layer and excellent optical properties thereof such as optical stability and transparency (high transmittance), the silica compound layer is suitable as one or more layers to be included when the multilayered light absorbing film is formed. Meanwhile, after the film formation, the silica compound layer has compressive stress and thus is bent so as to be convex toward the air side microscopically. On the other hand, the reverse stress layer has excellent optical properties, and after the film formation, has tensile stress acting in a direction opposite to the compressive stress, thereby canceling out the compressive stresses of the silica compound layers on both sides in the sandwich structure portion.

The reverse stress layer has tensile stress, and may be, for example, a ZrO₂ layer made of ZrO₂, a TiO₂ layer made of TiO₂, a NbzOs layer made of Nb₂O₅, or a HfOz made of hafnium oxide (in particular, HfOz).

Although not having such an extremely high density as to completely shut out moisture, the silica compound layer has a higher density than the reverse stress layer so that the silica compound layer allows less moisture to pass therethrough than the reverse stress layer and thus the moisture permeation amount is smaller.

Preferably, the sandwich structure portion is provided adjacently to the light absorbing layer. In a case where there are a plurality of light absorbing layers, the sandwich structure portion is preferably provided on the air side of the light absorbing layer that is closest to the substrate side.

The silica compound layer and the reverse stress layer may be formed by any method, and for example, may be formed by deposition or sputtering.

The silica compound layer preferably has such a density as to be obtained through deposition without ion-assisting. It is extremely difficult even for a person skilled in the art to directly measure the density of a deposited film. Meanwhile, specifying the degree of the density of the deposited film on the basis of whether or not ion-assisting is performed in deposition is easily understandable and useful for a person skilled in the art.

The light absorbing film may be formed such that the low refractive index layers and the high refractive index layers are alternately arranged so as to also have a function of an antireflection film as well as the light absorbing function. Here, the NiOₓ layer may be regarded as the high refractive index layer.

The base preferably has a front side and a back side as in a case of being used for spectacles or the like. The front side of a spectacle ND filter base is the environment side and the back side is the face side.

As the optical multilayer films, preferably, the antireflection film is provided on the front side of the base and the light absorbing film is provided on the back side. At present, the durability of the antireflection film is higher than that of the light absorbing film. Therefore, the antireflection film having relatively high durability is provided on the front side exposed to a severer environment, and the light absorbing film is provided on the back side which is relatively protected. Thus, it is possible to improve the durability as a whole while achieving favorable properties by ensuring the functions of light absorption (ND) and antireflection.

Such a ND filter is suitably used for spectacles. Specifically, the ND filter itself may be a spectacle lens, or the ND filter may be prepared for covering another spectacle lens.

In general spectacles (sunglasses), the absorption rate of visible light greatly varies among wavelengths in the visible region, and therefore the view differs in color, contrast, and the like as compared to naked eyes. In this regard, the spectacle ND filter according to the present invention uniformly absorbs visible light in the visible region and thus can provide visibility equivalent to that by naked eyes.

### Examples

Next, some preferred examples of the present invention and some comparative examples not belonging to the present invention (Examples 1 to 7 and Comparative examples 1 and 2) will be described.

As plastic base ND filters in Examples 1 to 7 and Comparative examples 1 and 2, spectacle convex lenses having a round shape with a diameter of 75 millimeters (mm) were prepared. The power of each lens was S-3.00.

The bases were selected from any of the following three types. The first type was a thiourethane resin base having a specific weight of 1.30 g/cm³ (gram per cubic centimeter), the refractive index was 1.60, and the Abbe number was 42 (Examples 1 to 5 and Comparative examples 1 and 2). The second type was a thiourethane resin base having a specific weight of 1.37 g/cm³, the refractive index was 1.67, and the Abbe number was 32 (Example 6). The third type was an episulfide resin base having a specific weight of 1.41 g/cm³, the refractive index was 1.70, and the Abbe number was 36 (Example 7).

On both of the front and back surfaces of each base, hard coating films (HC films) were formed. The hard coating films were all formed by applying the same hard coating solution in the same manner.

The hard coating solution was prepared as follows. First, 206 g (gram) of methanol, 300 g of a methanol-dispersed titania sol (manufactured by JGC Catalysts and Chemicals Ltd., rate of solid content 30%), 30 g of γ-glycidoxypropylmethyldiethoxysilane, and 60 g of tetraethoxysilane were dropped in a container, and 0.01 N (normality) of hydrochloric acid aqueous solution was dropped into the mixed solution. The resultant mixed solution was stirred and hydrolyzed. Next, 0.5 g of flow regulating agent and 1.0 g of catalyst were added, and the resultant solution was stirred at room temperature for three hours, to obtain the hard coating solution.

The hard coating solution was uniformly applied over the surface of the base by a spin coating method, and was then left in an environment of 120°C for 1.5 hours, whereby the hard coating solution was heat-cured, to obtain the hard coating film.

The physical film thickness of the hard coating film thus formed was 2.5 µm (micrometer).

Further, an antireflection film (AR film) and a water-repellent film were formed on the convex surface (front surface) side of each base.

Specifically, the base having the hard coating film was set in a fixing jig (dome), and was put into a vacuum device through a door. Thereafter, the door was closed, and the vacuum device was evacuated. The temperature in the vacuum device was maintained at 60°C in order to remove moisture from the base. When the degree of vacuum in the vacuum device reached 1.0E - 03(1.0×10⁻³) Pa (pascal), the following film formation was started. First, in order to enhance adhesion between the intermediate layer (hard coating film) and the optical multilayer film to be then formed, oxygen ions were applied to the surface of the base for 60 seconds, thus activating the surface of the base.

Next, SiOz as the low refractive index material and ZrOz as the high refractive index material were alternately deposited for predetermined periods respectively, whereby an antireflection film having a total of five layers each having a desired film thickness was formed on the convex surface of the base.

As SiOz, "SiOz" manufactured by Canon Optron Inc. was used, and was deposited at a film forming rate of 10.0 A/s (angstrom per second). After the film formation, the refractive index (reference wavelength λ = 500 nm) of the SiOz layer was 1.465.

As ZrOz, "ZrOz" manufactured by Canon Optron Inc. was used, and was deposited at a film forming rate of 6.0 Å/s. After the film formation, the refractive index (λ = 500 nm) of the ZrO₂ layer was 2.037.

Subsequently, in the vacuum device, a water repellent agent was deposited on the convex surface side of the base having the antireflection film, whereby the water-repellent film (top layer) was formed on the antireflection film.

The structures of the optical multilayer films on the convex surface side in Examples 1 to 7 and Comparative examples 1 and 2 are as shown below in Table 1. Unless otherwise specified, the film thickness is a physical film thickness.

**[Table 1]**

| | Material, etc. | Film thickness (nm) |
|---|---|---|
| - | Base | - |
| - | HC film | - |
| 1 | SiO₂ | 80 |
| 2 | ZrO₂ | 30 |
| 3 | SiO₂ | 30 |
| 4 | ZrO₂ | 60 |
| 5 | SiO₂ | 90 |
| 6 | Water-repellent film | - |

In addition, a light absorbing film and a water-repellent film were formed on the concave surface (back surface) side of the base.

Specifically, formation of the light absorbing film was performed with the film formation start condition arranged as in formation of the antireflection film. In the film formation, after oxygen ions were similarly applied to the front surface of the base, films of the following materials were formed with the following conditions. In deposition of the light absorbing film, in order to prevent the moisture barrier property from being excessively enhanced due to the layer density becoming a predetermined value or greater, ions were not applied except for the initial oxygen ion application, and the light absorbing film was deposited without ion-assisting (non-Ion Assist Deposition).

A ZrO₂ layer was formed in the same manner as in the case of the AR film described above.

As a mixture material (SiO₂ + Al₂O₃) of SiO₂ and Al₂O₃, which belongs to the silica compound, "Substance L5 HD" manufactured by Merck Performance Materials Ltd. was used, and was deposited at a film forming rate of 10.0 Å/s (angstrom per second). After the film formation, the refractive index (reference wavelength λ = 500 nm) of the SiO₂+Al₂O₃ layer was 1.477. In general, in a SiO₂+Al₂O₃ mixture material, the weight of SiO₂ is greater than the weight of Al₂O₃, and for example, the ratio of the weight of Al₂O₃ to the weight of SiO₂ is about several %. In the present invention, the weight ratio between SiO₂ and Al₂O₃ is not particularly limited, and components of the silica compound are not limited to SiO₂ and Al₂O₃.

As Al₂O₃, "Al₂O₃" manufactured by Canon Optron Inc. was used, and was deposited at a film forming rate of 10.0 Å/s. After the film formation, the refractive index (λ = 500 nm) was 1.629.

As Ni for NiOₓ, Ni manufactured by Kojundo Chemical Laboratory Co., Ltd. was used, and was deposited at a film forming rate of 3.0 Å/s. In this deposition, oxygen gas was supplied at a flow rate of 10 sccm (standard cubic centimeter per minute), to form a NiOₓ layer. After the film formation, the refractive index (λ = 500 nm) of the NiOₓ layer was 1.928, and the extinction coefficient was 2.134. The refractive index of the NiOₓ layer was relatively high at about 2.00, and therefore the NiOₓ layer could be used as a high refractive index layer.

In addition, on the light absorbing film (on the air side), a water-repellent film was formed in the same manner as that on the antireflection film.

In Examples 1 to 5 and Comparative examples 1 and 2, only the structures of the light absorbing films were different from each other. The structures of the light absorbing films in Examples 6 and 7 were the same as that in Example 5, and the bases were different as described above. The structures of the respective light absorbing films were as shown in Tables 2 to 4.

**[Table 2]**

| | Comparative example 1 | | Comparative example 2 | |
|---|---|---|---|---|
| | Material, etc. | Film thickness (nm) | Material, etc. | Film thickness (nm) |
| | Thiourethane base (1.60) | - | Thiourethane base (1.60) | - |
| - | HC film | - | HC film | - |
| 1 | Al₂O₃ | 40 | ZrO₂ | 10 |
| 2 | NiOₓ | 4.5 | SiO₂+Al₂O₃ | 45 |
| 3 | SiO₂+Al₂O₃ | 60 | NiOₓ | 4.5 |
| 4 | NiOₓ | 5.5 | SiO₂+Al₂O₃ | 60 |
| 5 | SiO₂+Al₂O₃ | 50 | NiOₓ | 5.5 |
| 6 | NiOₓ | 5.5 | SiO₂+Al₂O₃ | 50 |
| 7 | SiO₂+Al₂O₃ | 65 | NiOₓ | 5.5 |
| 8 | Water-repellent film | - | SiO₂+Al₂O₃ | 65 |
| 9 | - | - | Water-repellent film | - |

**[Table 3]**

| | Example 1 | | Example 2 | | Example 3 | | Example 4 | |
|---|---|---|---|---|---|---|---|---|
| | Material, etc. | Film thickness (nm) | Material, etc. | Film thickness (nm) | Material, etc. | Film thickness (nm) | Material, etc. | Film thickness (nm) |
| | Thiourethane base (1.60) | - | Thiourethane base (1.60) | - | Thiourethane base (1.60) | - | Thiourethane base (1.60) | - |
| - | HC film | - | HC film | - | HC film | - | HC film | - |
| 1 | ZrO₂ | 10 | ZrO₂ | 10 | ZrO₂ | 10 | ZrO₂ | 10 |
| 2 | SiO₂+Al₂O₃ | 45 | SiO₂+Al₂O₃ | 45 | SiO₂+Al₂O₃ | 45 | SiO₂+Al₂O₃ | 45 |
| 3 | NiOₓ | 4.5 | NiOₓ | 4.5 | NiOₓ | 4.5 | NiOₓ | 4.5 |
| 4 | SiO₂+Al₂O₃ | 30 | SiO₂+Al₂O₃ | 30 | SiO₂+Al₂O₃ | 30 | SiO₂+Al₂O₃ | 25 |
| 5 | ZrO₂ | 10 | ZrO₂ | 10 | ZrO₂ | 15 | ZrO₂ | 15 |
| 6 | SiO₂+Al₂O₃ | 30 | SiO₂+Al₂O₃ | 30 | SiO₂+Al₂O₃ | 30 | SiO₂+Al₂O₃ | 25 |
| 7 | NiOₓ | 5.5 | NiOₓ | 5.5 | NiOₓ | 5.5 | NiOₓ | 5.5 |
| 8 | SiO₂+Al₂O₃ | 50 | SiO₂+Al₂O₃ | 25 | SiO₂+Al₂O₃ | 50 | SiO₂+Al₂O₃ | 50 |
| 9 | NiOₓ | 5.5 | ZrO₂ | 10 | NiOₓ | 5.5 | NiOₓ | 5.5 |
| 10 | SiO₂+Al₂O₃ | 65 | SiO₂+Al₂O₃ | 25 | SiO₂+Al₂O₃ | 65 | SiO₂+Al₂O₃ | 65 |
| 11 | Water-repellent film | - | NiOₓ | 5.5 | Water-repellent film | - | Water-repellent film | - |
| 12 | - | - | SiO₂+Al₂O₃ | 65 | - | - | - | - |
| 13 | - | - | Water-repellent film | - | - | - | - | - |

**[Table 4]**

| | Example 5 | | Example 6 | | Example 7 | |
|---|---|---|---|---|---|---|
| | Material, etc. | Film thickness (nm) | Material, etc. | Film thickness (nm) | Material, etc. | Film thickness (nm) |
| | Thiourethane base (1.60) | - | Thiourethane base (1.67) | - | Episulfide base | - |
| - | HC film | - | HC film | - | HC film | - |
| 1 | ZrO₂ | 10 | ZrO₂ | 10 | ZrO₂ | 10 |
| 2 | SiO₂+Al₂O₃ | 45 | SiO₂+Al₂O₃ | 45 | SiO₂+Al₂O₃ | 45 |
| 3 | NiOₓ | 4.5 | NiOₓ | 4.5 | NiOₓ | 4.5 |
| 4 | SiO₂+Al₂O₃ | 20 | SiO₂+Al₂O₃ | 20 | SiO₂+Al₂O₃ | 20 |
| 5 | ZrO₂ | 15 | ZrO₂ | 15 | ZrO₂ | 15 |
| 6 | SiO₂+Al₂O₃ | 30 | SiO₂+Al₂O₃ | 30 | SiO₂+Al₂O₃ | 30 |
| 7 | NiOₓ | 5.5 | NiOₓ | 5.5 | NiOₓ | 5.5 |
| 8 | SiO₂+Al₂O₃ | 50 | SiO₂+Al₂O₃ | 50 | SiO₂+Al₂O₃ | 50 |
| 9 | NiOₓ | 5.5 | NiOₓ | 5.5 | NiOₓ | 5.5 |
| 10 | SiO₂+Al₂O₃ | 65 | SiO₂+Al₂O₃ | 65 | SiO₂+Al₂O₃ | 65 |
| 11 | Water-repellent film | - | Water-repellent film | - | Water-repellent film | - |

Here, whether or not ion-assisting was performed and the result of a test for the density (water vapor permeability closely associated with the density) of the deposited film, for the SiOz film and the Al₂O₃ film, are indicated below in Table 5. In the "No." column in Table 5, the order from the highest water vapor permeability is described.

In this test, a PET (polyethylene terephthalate) film was used as a base. Then, a water vapor permeability (gram per cubic meter for one day, g/m²·day) was measured for a case where only the base was used, and for cases where a SiOz film, an Al₂O₃ film, or a SiO₂+Al₂O₃ mixture film was deposited on the base in both conditions of using ion-assisting and not using ion-assisting.

In the case where only the base was used, the water vapor permeability was 7.29.

On the other hand, in the case where the SiO₂ film, the Al₂O₃ film, or the SiO₂+Al₂O₃ mixture film (deposition materials are described in the "material" column in Table 5) was deposited without ion-assisting such that the film thicknesses were 90.3 nm, 94.8 nm, and 74.4 nm, the water vapor permeabilities were 6.75, 6.28, and 6.12, which were slightly lower than that in the case where only the base was used. This is because the SiO₂ film, the Al₂O₃ film, or the SiO₂+Al₂O₃ mixture film prevented permeation of water vapor.

Further, in the case where the SiO₂ film was deposited with ion-assisting (acceleration voltage of 900 volts (V), acceleration current of 900 milliamperes (mA), bias current of 600 mA, and introduced oxygen (O₂) gas at 50 sccm, by means of an ion gun) such that the film thickness was 69.1 nm, the water vapor permeability was 3.77 and thus was more greatly reduced. This is because the density of the SiOz film formed by ion-assisted deposition was greater than the density in the case of not performing ion-assisting, and the SiOz film having such a great density further prevented permeation of water vapor.

Similarly, in the case where the Al₂O₃ film was deposited with ion-assisting (acceleration voltage of 1000 V, acceleration current of 1000 mA, bias current of 600 mA, and introduced oxygen gas at 50 sccm) such that the film thickness was 79.0 nm, the water vapor permeability was 0.89 and thus was greatly reduced. This is because the density of the Al₂O₃ film formed by ion-assisted deposition was greater than the density in the case of not performing ion-assisting, and the Al₂O₃ film having such a great density further prevented permeation of water vapor.

Further, similarly, in the case where the SiO₂+Al₂O₃ mixture film was deposited with similar ion-assisting as in the SiOz film such that the film thickness was 75.0 nm, the water vapor permeability was 1.61 and thus was low. This is because the density of the SiO₂+Al₂O₃ mixture film formed by ion-assisted deposition was greater than the density in the case of not performing ion-assisting, and the SiO₂+Al₂O₃ mixture film having such a great density further prevented permeation of water vapor.

**[Table 5]**

| No. | Water vapor permeability [g/m²·day] | Material | Ion-assisted process | Film thickness [nm] | Ion gun state | | | |
|---|---|---|---|---|---|---|---|---|
| | | | | | Acceleration voltage [V] | Acceleration current [mA] | Bias current [mA] | Introduced gas Oz [sccm] |
| 1 | 7.29 | Only PET film | --- | - | - | - | - | - |
| 2 | 6.75 | SiO₂ | Not performed | 90.3 | - | - | - | - |
| 3 | 6.28 | Al₂O₃ | Not performed | 94.8 | - | - | - | - |
| 4 | 6.12 | SiO₂+Al₂O₃ | Not performed | 74.4 | - | - | - | - |
| 5 | 3.77 | SiO₂ | Performed | 69.1 | 900 | 900 | 600 | 50 |
| 7 | 0.89 | Al₂O₃ | Performed | 79.0 | 1000 | 1000 | 600 | 50 |
| 6 | 1.61 | SiO₂+Al₂O₃ | Performed | 75.0 | 900 | 900 | 600 | 50 |

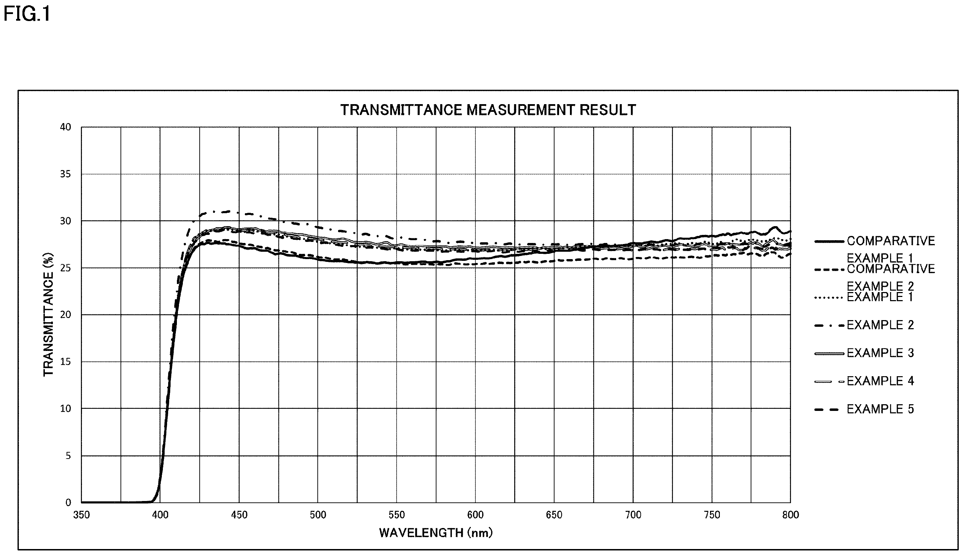

FIG. 1 is a graph showing spectral transmittance distributions in a visible region (wavelength is 400 nm to 700 nm) and a neighboring region, in Examples 1 to 5 and Comparative examples 1 and 2.

The spectral transmittance distributions were measured by a spectrophotometer (U-4100 manufactured by Hitachi High-Technologies Corporation).

In each of Examples 1 to 5 and Comparative examples 1 and 2, the transmittance in the visible region was within a band-shaped region of 27.5±4%, and visible light was uniformly absorbed at about an absorption rate of 27.5%, thus obtaining such a spectacle ND filter that a color recognized during wearing had almost no difference from that recognized by naked eyes while exhibiting a gray outer appearance. The absorption rate in the uniform absorption can be variously changed mainly by increasing/decreasing the total film thickness (the sum of film thicknesses) of the NiOₓ layers.

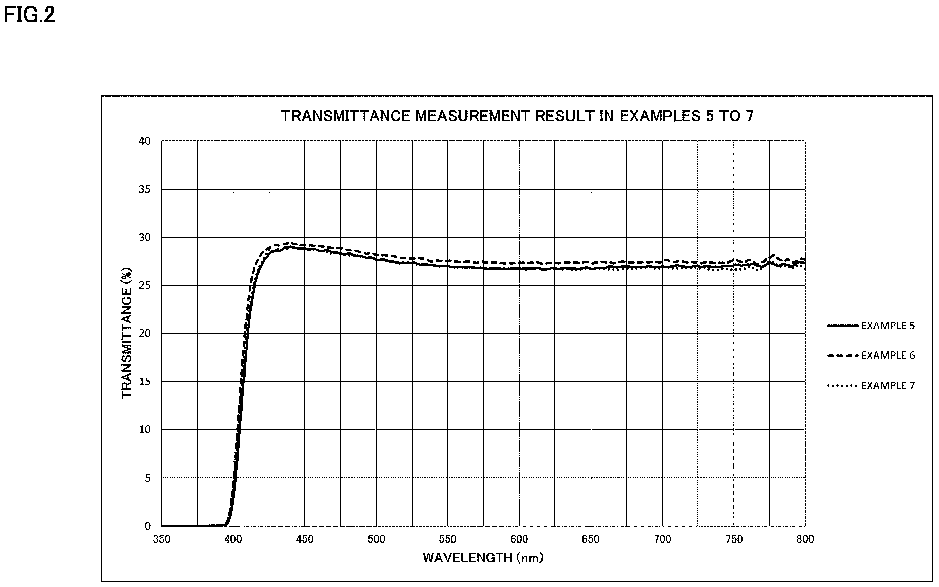

FIG. 2 is a graph showing spectral transmittance distributions in the visible region and the neighboring region, in Examples 5 to 7.

The spectral transmittance distribution in Example 5 (thiourethane base with a refractive index of 1.60) is the same as that shown in FIG. 1. In each of the spectral transmittance distributions in Example 6 (thiourethane base with a refractive index of 1.67) and Example 7 (episulfide base with a refractive index of 1.70), uniform absorption rates of about 27.5% were exhibited in the visible region, as in Example 5.

In addition, according to Examples 1 to 7, Comparative examples 1 and 2, and a result of simulation, it has been found that, as long as the film thickness of the NiOₓ layer is not greater than 6 nm, the stress difference relaxing effect by the sandwich structure portion (reverse stress layer) is exerted well also in relation with the NiOₓ layer. If absorption of visible light is insufficient when the thickness of the NiOₓ layer is reduced, a plurality of layers (not greater than 6 nm) may be provided (division of the light absorbing layer).

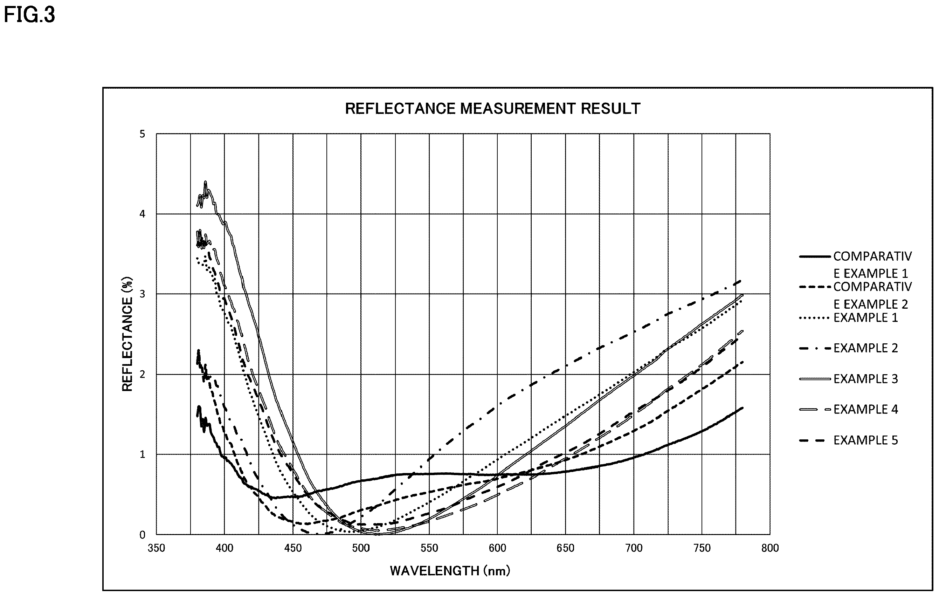

FIG. 3 is a graph showing spectral reflectance distributions (one surface) in the visible region and the neighboring region, on the concave surface (ND film formed surface) side in Examples 1 to 5 and Comparative examples 1 and 2.

The spectral reflectance distributions were measured by a reflectometer (USPM-RU manufactured by Olympus Corporation).

On the concave surface side in Examples 1 to 5 and Comparative examples 1 and 2, the reflectance was not greater than 4% in the visible region, and a minimum value in the reflectance distribution (minimum value in the overall distribution) was in a green color region (approximately not less than 450 nm and not greater than 580 nm) which was greatly associated with visibility. Therefore, each light absorbing film functions also as an antireflection film.

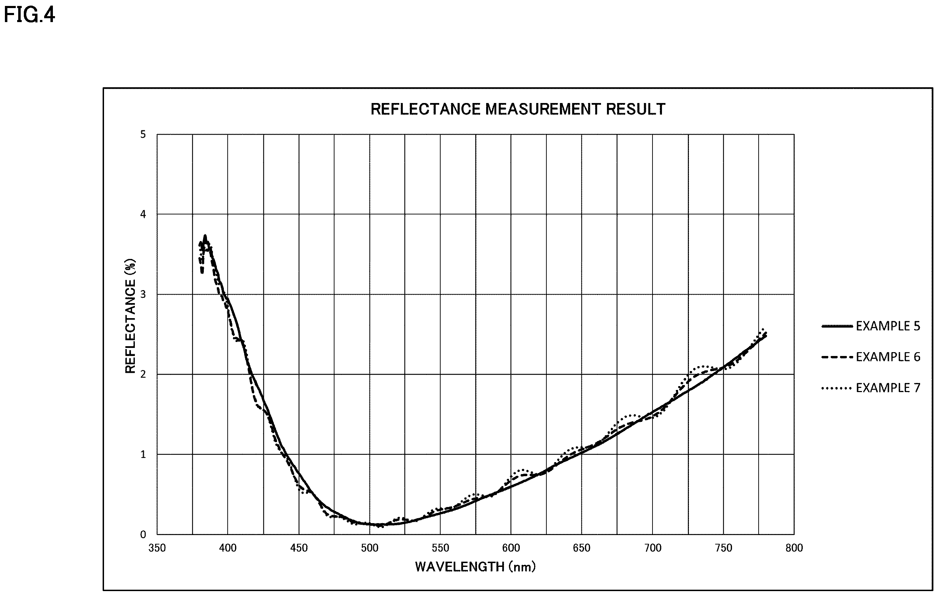

FIG. 4 is a graph similar to FIG. 3, for the concave surface (ND film formed surface) side in Examples 5 to 7.

Also on the concave surface side in Examples 5 to 7, the reflectance was not greater than 4% in the visible region, and a minimum value in the reflectance distribution (minimum value in the overall distribution) was in a green color region which was greatly associated with visibility and a neighboring region thereof (approximately not less than 440 nm and not greater than 580 nm). Therefore, each light absorbing film functions also as an antireflection film.

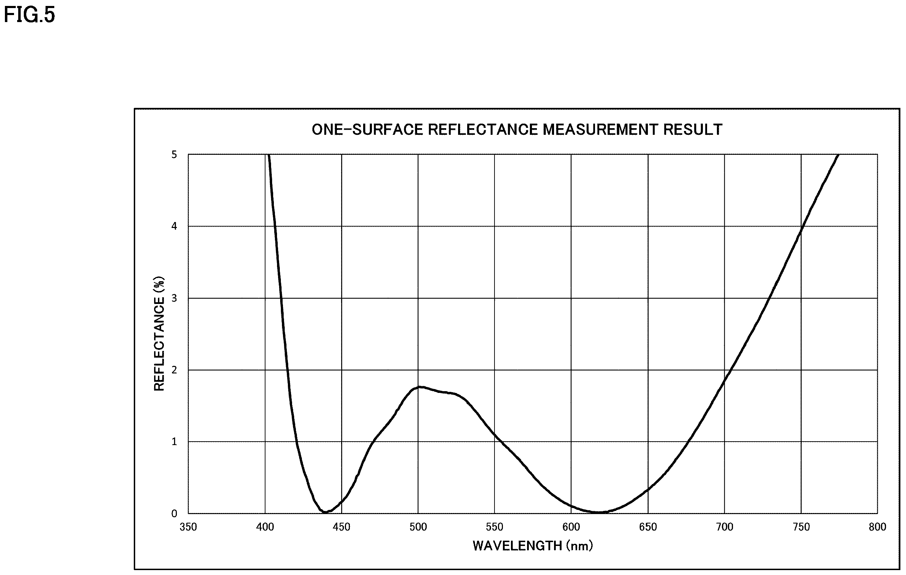

FIG. 5 is a graph showing a similarly measured spectral reflectance distribution (one surface, common) in the visible region on the convex surface side in Examples 1 to 5 and Comparative examples 1 and 2.

Also on the convex surface side in Examples 1 to 5 and Comparative examples 1 and 2, the reflectance was approximately not greater than 4% in the visible region. Further, in a region not less than 420 nm and not greater than 700 nm corresponding to the major part of the visible region, the reflectance was not greater than 2%. Thus, reflection of the visible light was sufficiently prevented on the convex surface side.

In Examples 6 and 7, the same reflectance distributions (one surface) on the convex surface side as those in Examples 1 to 5 and Comparative examples 1 and 2 were obtained.

In Examples 1 to 7 and Comparative examples 1 and 2, the function as the ND filter (uniform absorption) was sufficiently exhibited on only the concave surface side where the light absorbing film was provided. Therefore, an antireflection film aiming to further enhance the antireflection function was provided on the convex surface side.

Tables 6 and 7 below show results of various tests for durability, i.e., a constant temperature and humidity test, a constant temperature and humidity test after lens shape processing, and a weather-resistance and adhesion test for the concave surface, in Examples 1 to 7 and Comparative examples 1 and 2.

In the constant temperature and humidity test, a constant temperature and humidity tester (LHU-113 manufactured by ESPEC CORP.) was used, and each ND filter was put in the tester having the environment of 60°C and 90%. After elapse of one day, three days, and seven days from the start of the putting, the ND filter was temporarily taken out, and whether or not abnormality of an outer appearance such as expansion, color change, or crack occurred was observed.

In the constant temperature and humidity test after lens shape processing, in each of Examples 1 to 7 and Comparative examples 1 and 2, lens shape processing was performed through cutting in a concentric shape having a diameter of 50 mm with a center part held, and thereafter the same procedure as in the above constant temperature and humidity test was performed (excluding observation after elapse of seven days).

In the weather-resistance and adhesion test for the concave surface (light-absorbing-film formed surface), each concave surface was cut by a cutter so as to form 100 cells thereon in total, and a cellophane tape was adhered over the entirety of the cells and then vigorously peeled. This was repeated five times in total, and the number of cells where peeling did not occur therein was confirmed after completion of the total five-time peeling (initial). Further, the ND filter was put into a sunshine weather meter (S80B manufactured by Suga Test Instruments Co., Ltd.), and was taken out when the putting time reached 60 hours (h). Then, the above cell formation, five-time cellophane tape peeling, and confirmation of the number of cells, were performed. Similarly, the ND filter was further put, and also when the putting time reached 120 hours, 180 hours, and 240 hours in total, the above cell formation, five-time cellophane tape peeling, and confirmation of the number of cells, were performed.

**[Table 6]**

| | | Comparative example 1 | Comparative example 2 | Example 1 | Example 2 | Example 3 |
|---|---|---|---|---|---|---|
| Base | Material | Thiourethane | Thiourethane | Thiourethane | Thiourethane | Thiourethane |
| | Refractive index | 1.60 | 1.60 | 1.60 | 1.60 | 1.60 |
| Constant temperature and humidity test 60°C, 90% RH | First day | Changed | No change | No change | No change | No change |
| | Third day | Changed | No change | No change | No change | No change |
| | Seventh day | Changed | Changed | Changed | Changed | Changed |
| Constant temperature and humidity test after lens shape processing | First day | Changed | No change | No change | No change | No change |
| | Third day | Changed | No change | No change | No change | No change |
| Weather-resistance and adhesion test, concave surface (ND film formed surface) | Initial | 100 | 100 | 100 | 100 | 100 |
| | 60 h | 100 | 99 | 100 | 100 | 100 |
| | 120 h | 100 | 90 | 99 | 99 | 100 |
| | 180 h | 100 | 75 | 98 | 98 | 99 |
| | 240 h | 100 | 60 | 95 | 95 | 97 |

**[Table 7]**

| | | Example 4 | Example 5 | Example 6 | Example 7 |
|---|---|---|---|---|---|
| Base | Material | Thiourethane | Thiourethane | Thiourethane | Episulfide |
| | Refractive index | 1.60 | 1.60 | 1.67 | 1.70 |
| Constant temperature and humidity test 60°C, 90% RH | First day | No change | No change | No change | No change |
| | Third day | No change | No change | No change | No change |
| | Seventh day | Changed | Changed | No change | No change |
| Constant temperature and humidity test after lens shape processing | First day | No change | No change | No change | No change |
| | Third day | No change | No change | No change | No change |
| Weather-resistance and adhesion test, concave surface (ND film formed surface) | Initial | 100 | 100 | 100 | 100 |
| | 60 h | 100 | 100 | 100 | 100 |
| | 120 h | 100 | 100 | 100 | 100 |
| | 180 h | 100 | 100 | 100 | 100 |
| | 240 h | 99 | 100 | 100 | 100 |

In Examples 1 to 5 and Comparative example 2, in the constant temperature and humidity test, abnormality of the outer appearance was not observed until elapse of three days ("no change"), and color change in the peripheral portion and occurrence of crack were recognized after elapse of seven days ("changed").

In Examples 6 and 7, abnormality of the outer appearance was not observed even after elapse of seven days. In Comparative example 1, optical strain occurred from when one day was elapsed.

The light absorbing film in Comparative example 1 had the Al₂O₃ layer in the first layer (initial layer) from the base, and therefore it is considered that the Al₂O₃ layer could not follow swelling of the thiourethane resin base which absorbed a relatively large amount of moisture, thus causing optical strain.

On the other hand, in Examples 1 to 7 and Comparative example 2, the initial layer was the ZrOz layer, and therefore it is inferred that the ZrO₂ layer followed swelling of the thiourethane base and thus occurrence of optical strain was prevented.

In Examples 1 to 7 and Comparative example 2, in the constant temperature and humidity test after lens shape processing, abnormality of the outer appearance was not observed until elapse of three days.

On the other hand, in Comparative example 1, a linear-shaped color change occurred at a lens center portion. Such color change was not confirmed immediately after the lens shape processing. As a cause of the color change, it is considered that slight crack occurred at the lens center portion which was the lens held portion in the lens shape processing, and through humidification, moisture concentrated on the crack, so that the NiOₓ layer was locally altered, resulting in abnormality of the transmittance.

Al₂O₃ exhibits a smaller deformation amount with respect to an external force, as compared to ZrOz and SiO₂. In addition, the thiourethane resin is more readily deformed by an external force than the episulfide resin. Therefore, in Comparative example 1, it is considered that the lens surface was slightly bent due to holding in the lens shape processing, and the bending amount was larger in the thiourethane base and therefore the bending could not be followed by the Al₂O₃ layer, resulting in crack.

On the other hand, in Examples 1 to 7 and Comparative example 2, the Al₂O₃ layer was not used, and the SiO₂+Al₂O₃ layer and the ZrO₂ layer were used. Therefore, it is inferred that, in spite of the thiourethane base (in Example 7, episulfide base), the SiO₂+Al₂O₃ layer and the ZrO₂ layer followed bending of the lens surface in the lens shape processing, and thus crack did not occur even under exposure to the constant temperature and humidity environment after the lens shape processing.

Further, in Examples 1 to 7 and Comparative example 1, in the weather-resistance and adhesion test, the number of cells where peeling occurred was five or less even when 240 hours elapsed, and thus favorable weather resistance was exhibited. In particular, in Examples 5 to 7 and Comparative example 1, peeling did not occur at any cell (no peeling at 100 cells) even when 240 hours elapsed, and thus favorable weather resistance was exhibited.

On the other hand, in Comparative example 2, peeling occurred at 25 cells (no peeling at 75 cells) when 180 hours elapsed, and peeling occurred at 40 cells (no peeling at 60 cells) when 240 hours elapsed, thus exhibiting lower weather resistance.

As a cause of such lower weather resistance in Comparative example 2, it is considered that every NiOₓ layer was sandwiched between the SiO₂+Al₂O₃ layers and compressive stresses in the SiO₂+Al₂O₃ layers were overlapped in the same direction, so that adhesion of the SiO₂+Al₂O₃ layer to the NiOₓ layer was lowered.

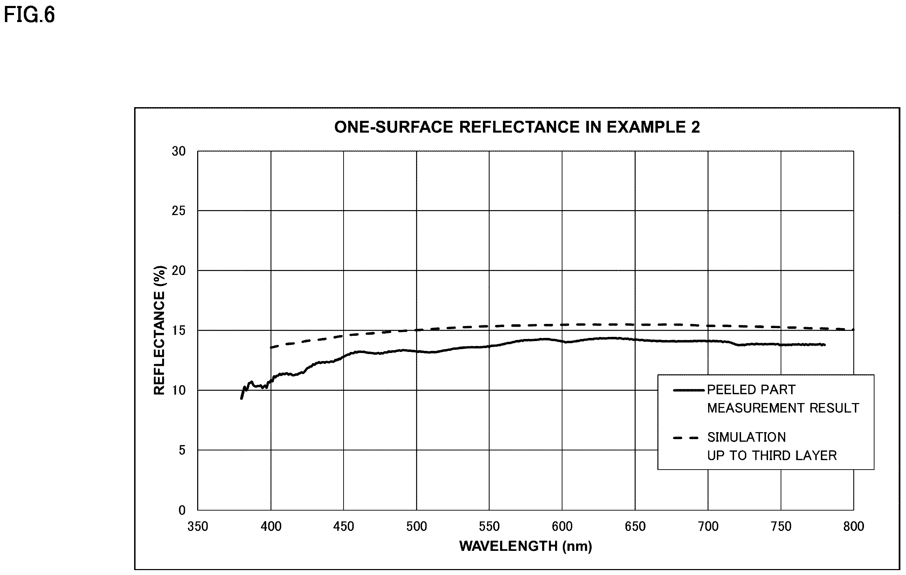

FIG. 6 is a graph showing spectral reflectance distributions (one surface) in the visible region and the neighboring region, for a part where peeling occurred (peeled part) after the weather-resistance and adhesion test in Comparative example 2, and simulation in a case where the layers up to the third layer from the base side remained in the light absorbing film while the fourth and subsequent layers were lost.

In view of the situation in FIG. 6 where the distribution based on the simulation up to the third layer and the distribution at the peeled part are similar to each other, and the like, it is inferred that peeling occurred between the NiOₓ layer at the third layer and the SiO₂+Al₂O₃ layer at the fourth layer from the base side.

Example 1 had such a structure that the SiO₂+Al₂O₃ layer (film thickness-is 60 nm) at the fourth layer in Comparative example 2 was replaced with the sandwich structure portion (film thicknesses are 30, 10, 30 nm) in which the ZrOz layer was sandwiched between the SiO₂+Al₂O₃ layers. Thus, stress in the air-side layer adjacent to the NiOₓ layer at the third layer where peeling could occur in the weather-resistance and adhesion test was relaxed, and thus favorable weather resistance and adhesion were obtained in Example 1. Owing to the sandwich structure portion, the first and second NiOₓ layers from the base side were each adjacent to not the ZrO₂ layer but the SiO₂+Al₂O₃ layer, and thereby were protected from moisture.

Example 2 had such a structure that the SiO₂+Al₂O₃ layer (film thickness is 50 nm) adjacent, on the air side, to the second NiOₓ layer (the seventh layer) from the base side in Example 1 was replaced with the sandwich structure portion (film thicknesses are 25, 10, 25 nm). In the weather-resistance and adhesion test, Example 2 exhibited a result equivalent to that in Example 1, and therefore it can be said that, even though the sandwich structure portion was added to the second NiOₓ layer from the base side, weather resistance and adhesion in Example 2 did not differ from Example 1 and thus were not improved very much.

Example 3 had such a structure that the film thickness of the ZrOz layer of the sandwich structure portion in Example 1 was increased (from 10 nm to 15 nm). The film thickness of the ZrOz layer reached the half (50%) of the thickness of one SiO₂+Al₂O₃ layer (film thickness is 30 nm) and reached 1/4 (25%) of the total film thickness of the SiO₂+Al₂O₃ layers of the sandwich structure portion. Example 3 exhibited an improved result in the weather-resistance and adhesion test, as compared to Example 1. It is considered that such improvement was due to increase in the stress relaxing effect by the ZrOz layer.

Example 4 had such a structure that the film thickness of each SiO₂+Al₂O₃ layer of the sandwich structure portion in Example 3 was decreased (from 30 nm to 25 nm). By this decrease, as compared to Example 3, the ratio of the film thickness of the ZrOz layer to the film thickness of one SiO₂+Al₂O₃ layer in the sandwich structure portion was increased to 60%, and the ratio thereof to the total film thickness of the SiO₂+Al₂O₃ layers was increased to 30%. Thus, the stress relaxing effect by the ZrOz layer was further increased and Example 4 exhibited an improved result in the weather-resistance and adhesion test as compared to Example 3. Even if the total film thickness of the SiO₂+Al₂O₃ layers was decreased to such an extent, optical properties such as antireflection property in the light absorbing film were not significantly influenced partly because the ZrOz layer (high refractive index layer) was added.

Example 5 had such a structure that, in the sandwich structure portion in Example 4, the film thickness of the SiO₂+Al₂O₃ layer on the base side was decreased (from 25 nm to 20 nm) and the film thickness of the SiO₂+Al₂O₃ layer on the air side was increased (from 25 nm to 30 nm) by the amount corresponding to the decrease, so that the film thickness on the base side was made smaller than the film thickness on the air side. The film thickness of the SiO₂+Al₂O₃ layer adjacent, on the air side, to the NiOₓ layer closest to the base side (at the third layer) which was the part where peeling would occur, was decreased. Thus, stress directly acting on the NiOₓ layer was relaxed, thus exhibiting an extremely excellent result that peeling did not occur (100 cells remained) in the weather-resistance and adhesion test during 240 hours.

Example 6 had such a structure that the same light absorbing film as in Example 5 was formed on the thiourethane base having a refractive index of 1.67. In Example 6, optical strain did not occur in the constant temperature and humidity test on the seventh day, for example, and thus durability equivalent to or higher than that in Example 5 was obtained.

Example 7 had such a structure that the same light absorbing film as in Example 5 was formed on the episulfide base, and exhibited an extremely excellent durability equivalent to that in Example 6.

## Claims

1. A plastic base ND filter comprising:
a base made of plastic; and
a light absorbing film provided on at least one surface of the base and having a plurality of layers, wherein
the light absorbing film
includes one or more NiOₓ layers made of NiOₓ, x being not less than 0 and not greater than 1, and
includes a sandwich structure portion which is provided on an opposite side of at least one of the NiOₓ layers from the base and in which a reverse stress layer is sandwiched between silica compound layers, **characterized in that**
the light absorbing film includes a plurality of NiOx layers, and
the NiOₓ layers each have a physical film thickness of 6 nanometers or less.

2. The plastic base ND filter according to claim 1, wherein
the sandwich structure portion is provided so as to be adjacent, on the opposite side from the base, to the NiOₓ layer closest to the base.

3. The plastic base ND filter according to claim 1 or 2, wherein
the base is made of thiourethane resin.

4. The plastic base ND filter according to any one of claims 1 to 3, wherein
the reverse stress layer is at least one of a ZrO₂ layer made of ZrO₂, a TiO₂layer made of TiO₂, a Nb₂O₅ layer made of Nb₂O₅, and a HfO₂ layer made of HfO₂.

5. The plastic base ND filter according to any one of claims 1 to 4, wherein
the silica compound layer is a SiO₂+Al₂O₃ layer made of a mixture of SiO₂ and Al₂O₃.

6. The plastic base ND filter according to any one of claims 1 to 5, wherein
the silica compound layer has such a density as to be obtained through deposition without ion-assisting.

7. The plastic base ND filter according to any one of claims 1 to 6, wherein
the light absorbing film has low refractive index layers and high refractive index layers arranged alternately.

8. The plastic base ND filter according to claim 7, wherein
the base has a front surface and a back surface, and
the light absorbing film is provided on the back surface.

9. The plastic base ND filter according to claim 8, wherein
an antireflection film is provided on the front surface.

10. A spectacle plastic base ND filter comprising the plastic base ND filter according to any one of claims 1 to 9.

## Patentansprüche

1. Ein Kunststoff-Basis-ND-Filter, umfassend:
eine Basis, die aus Kunststoff hergestellt ist; und
einen lichtabsorbierenden Film, der auf mindestens einer Oberfläche der Basis bereitgestellt ist und eine Mehrzahl von Schichten aufweist, wobei
der lichtabsorbierende Film
eine oder mehrere NiOₓ-Schichten umfasst, die aus NiOₓ hergestellt sind, wobei x nicht kleiner als 0 und nicht größer als 1 ist, und
einen Sandwichstrukturabschnitt umfasst, der auf einer der Basis gegenüberliegenden Seite mindestens einer der NiOₓ-Schichten bereitgestellt ist und in dem eine Reversspannungsschicht zwischen Siliciumdioxidverbindungsschichten eingeschlossen ist, **dadurch gekennzeichnet, dass**
der lichtabsorbierende Film eine Mehrzahl von NiOx-Schichten umfasst, und
die NiOₓ-Schichten jeweils eine physikalische Filmdicke von 6 Nanometern oder weniger aufweisen.

2. Der Kunststoff-Basis-ND-Filter gemäß Anspruch 1, wobei
der Sandwichstrukturabschnitt so bereitgestellt ist, dass er an die der Basis gegenüberliegenden Seite der NiOx-Schicht, die der Basis am nächsten liegt, angrenzt.

3. Der Kunststoff-Basis-ND-Filter gemäß Anspruch 1 oder 2, wobei
die Basis aus Thiourethanharz hergestellt ist.

4. Der Kunststoff-Basis-ND-Filter gemäß einem der Ansprüche 1 bis 3, wobei
die Reversspannungsschicht mindestens eine aus einer aus ZrO₂ hergestellten ZrO₂ -Schicht, einer aus TiO₂ hergestellten TiO₂ -Schicht, einer aus Nb₂O₅ hergestellten Nb₂O₅ -Schicht und einer aus HfO₂ hergestellten HfO₂ -Schicht ist.

5. Der Kunststoff-Basis-ND-Filter gemäß einem der Ansprüche 1 bis 4, wobei
die Siliciumdioxidverbindungsschicht eine SiO₂+Al₂O₃ -Schicht ist, die aus einer Mischung aus SiO₂ und Al₂O₃ hergestellt ist.

6. Der Kunststoff-Basis-ND-Filter gemäß einem der Ansprüche 1 bis 5, wobei
die Siliciumdioxidverbindungsschicht eine solche Dichte aufweist, wie sie durch Abscheidung ohne lonenunterstützung erhalten wird.

7. Der Kunststoff-Basis-ND-Filter gemäß einem der Ansprüche 1 bis 6, wobei
der lichtabsorbierende Film Schichten mit niedrigem Brechungsindex und Schichten mit hohem Brechungsindex aufweist, die abwechselnd angeordnet sind.

8. Der Kunststoff-Basis-ND-Filter gemäß Anspruch 7, wobei
die Basis eine vordere Oberfläche und eine hintere Oberfläche aufweist, und
der lichtabsorbierende Film auf der hinteren Oberfläche bereitgestellt ist.

9. Der Kunststoff-Basis-ND-Filter gemäß Anspruch 8, wobei
ein Antireflexionsfilm auf der vorderen Oberfläche bereitgestellt ist.

10. Ein Brillen-Kunststoff-Basis-ND-Filter, umfassend den Kunststoff-Basis-ND-Filter gemäß einem der Ansprüche 1 bis 9.

## Revendications

1. Un filtre ND de base en plastique comprenant :
une base faite de plastique ; et
un film absorbant la lumière fourni sur au moins une surface de la base et ayant une pluralité de couches, dans lequel
le film absorbant la lumière
inclut une ou plusieurs couches de NiOₓ faites de NiOₓ, x n'étant pas inférieur à 0 et pas plus grand que 1, et
inclut une portion de structure en sandwich qui est fournie sur un côté opposé d'au moins une des couches de NiOₓ par rapport à la base et dans laquelle une couche de contrainte inverse est prise en sandwich entre des couches de composé de silice, **caractérisé en ce que**
le film absorbant la lumière inclut une pluralité de couches de NiOx, et
les couches de NiOₓ ont chacune une épaisseur de film physique de 6 nanomètres ou moins.

2. Le filtre ND de base en plastique selon la revendication 1, dans lequel
la portion de structure en sandwich est fournie de manière à être adjacente, sur le côté opposé par rapport à la base, à la couche de NiOₓ la plus proche de la base.

3. Le filtre ND de base en plastique selon la revendication 1 ou 2, dans lequel
la base est faite de résine de thiouréthane.

4. Le filtre ND de base en plastique selon l'une quelconque des revendications 1 à 3, dans lequel
la couche de contrainte inverse est au moins une parmi une couche de ZrO₂ faite de ZrO₂, une couche de TiO₂ faite de TiO₂ , une couche de Nb₂O₅ faite de Nb₂O₅ , et une couche de HfO₂ faite de HfO₂.

5. Le filtre ND de base en plastique selon l'une quelconque des revendications 1 à 4, dans lequel
la couche de composé de silice est une couche de SiO₂ + Al₂O₃ faite d'un mélange de SiO₂ et Al₂O₃ .

6. Le filtre ND de base en plastique selon l'une quelconque des revendications 1 à 5, dans lequel
la couche de composé de silice a une densité telle qu'elle est obtenue par dépôt sans assistance ionique.

7. Le filtre ND de base en plastique selon l'une quelconque des revendications 1 à 6, dans lequel
le film absorbant la lumière a des couches à faible indice de réfraction et des couches à indice de réfraction élevé agencées en alternance.

8. Le filtre ND de base en plastique selon la revendication 7, dans lequel
la base a une surface avant et une surface arrière, et
le film absorbant la lumière est fourni sur la surface arrière.

9. Le filtre ND de base en plastique selon la revendication 8, dans lequel
un film antireflet est fourni sur la surface avant.

10. Un filtre ND de base en plastique pour lunettes comprenant le filtre ND de base en plastique selon l'une quelconque des revendications 1 à 9.
